**Europäisches Patentamt**

**European Patent Office**

**Office européen des brevets**

(19)

(11) Publication number : **0 286 660 B1**

# EUROPEAN PATENT SPECIFICATION

(12)

(45) Date of publication of patent specification :
**04.03.92 Bulletin 92/10**

(51) Int. Cl.⁵ : **H01L 21/66, H01L 23/52**

(21) Application number : **87906629.8**

(22) Date of filing : **28.09.87**

(86) International application number :
**PCT/US87/02473**

(87) International publication number :
**WO 88/02549 07.04.88 Gazette 88/08**

(54) **METHOD AND CONFIGURATION FOR TESTING ELECTRONIC CIRCUITS AND INTEGRATED CIRCUIT CHIPS USING A REMOVABLE OVERLAY LAYER.**

(30) Priority : **26.09.86 US 912454**

(43) Date of publication of application :
**19.10.88 Bulletin 88/42**

(45) Publication of the grant of the patent :
**04.03.92 Bulletin 92/10**

(84) Designated Contracting States :
**DE FR GB IT NL SE**

(56) References cited :
**EP-A- 0 175 870**
**EP-A- 0 178 227**
**US-A- 4 426 773**
**Solid State Technology, volume 29, no. 3, March 1986, (Port Washington, New York, US), W. Lukaszek et al.: "CMOS test chip design for process problem debugging and yield prediction experiments", pages 87-93**
**IBM Technical Disclosure Bulletin, volume 24, no. 2, July 1981 (New York, US), L.V. Auletta et al.: "Flexible tape conductor interconnection for chips", pages 1214-1215**

(73) Proprietor : **GENERAL ELECTRIC COMPANY**
**1 River Road**
**Schenectady, NY 12345 (US)**

(72) Inventor : **EICHELBERGER, Charles, William**
**1256 Waverly Place**
**Schenectady, NY 12308 (US)**
Inventor : **WOJNAROWSKI, Robert, John**
**102 Hatlee Road, RD 6**
**Ballston Lake, NY 12019 (US)**
Inventor : **WELLES, Kenneth, Brakeley, II**
**315 Division Street**
**Schenectady, NY 12304 (US)**

(74) Representative : **Kennington, Eric Alasdair et al**
**London Patent Operation GENERAL ELECTRIC TECHNICAL SERVICES CO.**
**Burdett House 15-16 Buckingham Street**
**London WC2N 6DU (GB)**

## Description

The present invention relates to packaging electronic integrated circuit chips into operable chip systems in a manner to facilitate testability.

It is known from IBM Technical disclosure Bulletin Vol. 24 No. 2, July 1981, pages 1214 and 1215 to interconnect integrated circuit chips using flexible tape which also acts as a substrate on which conductors are supported. The tape may be of polyimide. On one surface of the tape there are a series of in-line chip connection sites each comprised of a plurality of solder balls. A series of metal lines are provided, some of the lines interconnecting the solder balls at adjacent sites and others providing common connections to input-output terminals. Conventional chips are solder bonded to the solder balls at the sites to provide a series of in-line chips.

It is known from EP-A-178227 to provide a wafer-scale integrated circuit. The wafer may be supported on a substrate. The circuit has circuit blocks arranged in a matrix fashion and isolated from each other by an intermediate area located between the circuit blocks. The circuit blocks are connected to an interconnecting circuit formed on an insulative film in order to complete the circuit. The insulative film is of a polymer, e.g. polyimide. The connection is performed by bonding corresponding bonding pads disposed on the circuit blocks and the interconnecting circuit by a conventional bonding process.

Before making the connection between the blocks, the blocks are individually tested by a computer aided testing apparatus and the defective circuit blocks are replaced by repair chips prepared in advance, without needing any additional work on the interconnecting circuits. The bonding pads disposed on the circuit blocks and repair chips are arranged in a predetermined layout pattern to allow interchangeability, the replacement of a defective circuit block being possible regardless of its location.

The repair chip is bonded onto the wafer at the position of the defective chip. The flexibility of the interconnecting film allows the protruding top surface of the repair chip to be accommodated.

It is also known to test a system at the lowest feasible functional level to identify defective parts so that a completely functioning system with a high degree of assured reliability can be produced. A first set of problems results from the deficiency of probing chips at the wafer level. Wafer probers are limited in speed of the chips that they can test due to the relatively long runs and high capacitive loading associated with the probes. Wafer probes are also limited in the total number of chip pads which can be probed at one time. Wafer probes are also limited to the maximum size of the pad which can be-probed. This limitation is exacerbated by large numbers of pads. Additionally, increased pin count is also becoming more prevalent with the advent of very large scale integration since more complexity can now be put on a given chip.

Another problem exists in testing systems where several chips must be interconnected to perform a given function. In particular, it may be impossible to detect a defective part until it is interconnected with other parts of the functional block. Examples of such cases include multiple chip microprocessor systems, fast fourier transform systems in which the system size is too large for a single chip, large parallel multiplying systems, and memory systems. It is possible to test the functional blocks after they are assembled into a complete system. However, testing would now be extremely complex and time consuming due to the constraints imposed by the large number of parameters which must be tested.

An additional problem is testing chips under burn-in conditions. The typical burn-in involves operating the system typically for a period of approximately 100 hours at high temperature conditions. Experience has shown that if a chip is apt to fail, it generally fails under these conditions within the 100 hour time period. The conventional approach to testing chips is to first test the chip at the probe station, recognizing deficiencies in the number of probes and in speed. The chips which pass these tests are packaged. In high reliability systems, the packaged chips are burned-in under power. After burn-in, the package chips are tested again to determine proper functionality. The packaged chips are then interconnected on a printed circuit board to form the final system. Because of size and speed constraints, it is desirable to incorporate several chips in the same package. This complicates burn-in because one failed chip in a package requires that the whole package, including all the good chips, be discarded.

According to one aspect of the present invention, there is provided a method of producing integrated circuit chip packages, said method comprising the steps of:

a) disposing a plurality of integrated circuit chips on a substrate, said chips having interconnect pads thereon;

b) disposing at least one test integrated circuit chip in said substrate, said test chip including means for driving at least one of said plurality of chips; and

c) disposing a removable polymer film over said test chip and said at least one of said plurality of chips, said film having at least some apertures therein in alignment with said interconnect pads and said film having metallization patterns thereon connecting selected ones of the pads on said test chip to selected ones of the pads on at least one of said plurality of chips.

According to another aspect, there is provided a method for producing integrated circuit chip packages, said method comprising the steps of: disposing a plurality of integrated circuit chips on a substrate, said chips having interconnect pads thereon; disposing a removable polymer overlay layer over said chips, said layer having at least some apertures therein in alignment with at least some of said interconnect pads, said layer also having a metallization pattern thereon for connecting said chips in a first configuration; testing said integrated circuit chips while connected in said first configuration; removing said overlay layer and said metallization; applying a second polymer overlay layer over said chips and said substrate, said second overlay layer having at least some apertures therein in alignment with at least some of said interconnect pads, said second overlay layer also having a metallization pattern thereof or connecting said chips in a second configuration. An embodiment of this aspect does not require a test chip.

According to a further aspect, there is provided an integrated circuit chip package comprising: a substrate; a plurality of integrated circuit chips disposed on said substrate, said integrated circuit chips having interconnect pads thereon; a removable polymer film overlay disposed over said chips and said substrate, said film having apertures therein exposing at least some of interconnect pads; and a pattern of metallization disposed on said film and connecting selected ones of the interconnect pads through said apertures; at least one of said chips-comprising a test chip operable to test at least one other of said chips.

Embodiments of the invention will now be discussed.

One embodiment of the present invention is generally directed to a method for interconnecting integrated circuit chips so as to allow them to be tested in their final configuration in terms of speed, operating environment packaging, temperature, voltage and proximity to other chips of the system. In this embodiment, a removable overlay layer is applied to chips positioned on a substrate. The interconnection pattern of the overlay layer is specifically designed to partition the system for easy testing. The interconnect density of the overlay structure and its very low capacitive loading permit the utilization of extremely high density patterns which can make interconnection to a chip possible, otherwise, chip systems cannot easily be tested. Probe stations are inadequate for such purposes because too many probes would be required or because the chip pads are too small to accommodate a probe or because the capacitive loading of the probe station is too high to allow the chip to operate at maximum speed.

Special test chips may be employed herein. If used, these test chips are placed on the substrate along with the operating chip or chip system for the purpose of testing circuits at speeds and under operating conditions which cannot be duplicated at the wafer probe level.

The removable overlay layer can be removed and reapplied several times if necessary with different wiring configurations and with removal and replacement of defective chips until the final operating configuration is established. There is no resulting degradation to the underlying chip. Alternate overlay configurations are possible. In one configuration, inferior, but easily processed materials are used to provide a test overlay layer thereby simplifying the process and exposing the chips to less stringent processing conditions. In a second configuration, a test overlay layer is applied over an already in place overlay layer for the purpose of simplifying partitioning and multiprobe testing of a complex system.

Thus, chips can be arranged in their final operating positions, and connected for the purpose of testing. Then all connections are removed and are reconnected in an operating configuration. Other interconnect systems, including hybrid circuits, printed circuits and hard-wiring are not amenable to easy removal of all interconnects and reapplication of the interconnections in a different form.

The invention both as to organization and method of practice, may be better understood by reference to the following description taken in connection with the accompanying drawings in which:

Figure 1 is an exploded isometric view illustrating a multichip circuit with a test overlay layer;

Figure 2 is an exploded view similar to Figure 1 but more particularly showing the utilization of a special test chip connected to the other chips in the circuit by means of a different overlay layer;

Figure 3 is an exploded isometric view illustrating a multichip circuit package with operational overlay layer;

Figure 4A illustrates means to probe internal test points with a reduced number of external pins;

Figure 4B is a schematic diagram illustrating the use of memory means to supply test vectors and to store test results on a packaged substrate assembly;

Figure 4C is a schematic diagram similar to Figure 4B more particularly illustrating the utilization of a microcomputer chip to compute test vectors and to evaluate test results;

Figure 5 is an exploded isometric view illustrating a multichip circuit assembly which simultaneously employs an operational circuit overlay layer and a test overlay layer.

A related patent application PCT/US87/02501 filed 28 September 1987, publication No. WO88/02551 (RD17433 European Application No. 87906964.9), describes a method and apparatus for applying a removable polymer overlay layer. A second related patent application PCT/US87/02293 filed 14 September 1987, publication No. WO88/02550 (RD17428, European Application No. 87906271.9) describes a preferable method for supplying the overlay layer with a pattern of apertures for connection to the above-described interconnect pads. A third related patent application PCT/US87/02294 filed 14 September 1987, publication No. WO88/02552 (RD17432 European Application No. 87906695.5) describes a method for providing a preferred form of metallization patterning over a polymer film. All three of these applications are hereby incorporated herein by reference. These applications are assigned to the same assignee as the present invention.

The first of the aforementioned patent applications in particular discloses a method involving few steps and using easy-to-use materials. The methods disclosed therein are generally more suitable for test layers since the test layer is easily processed and easily removed and since long term thermal and hydrolitic stability is not required.

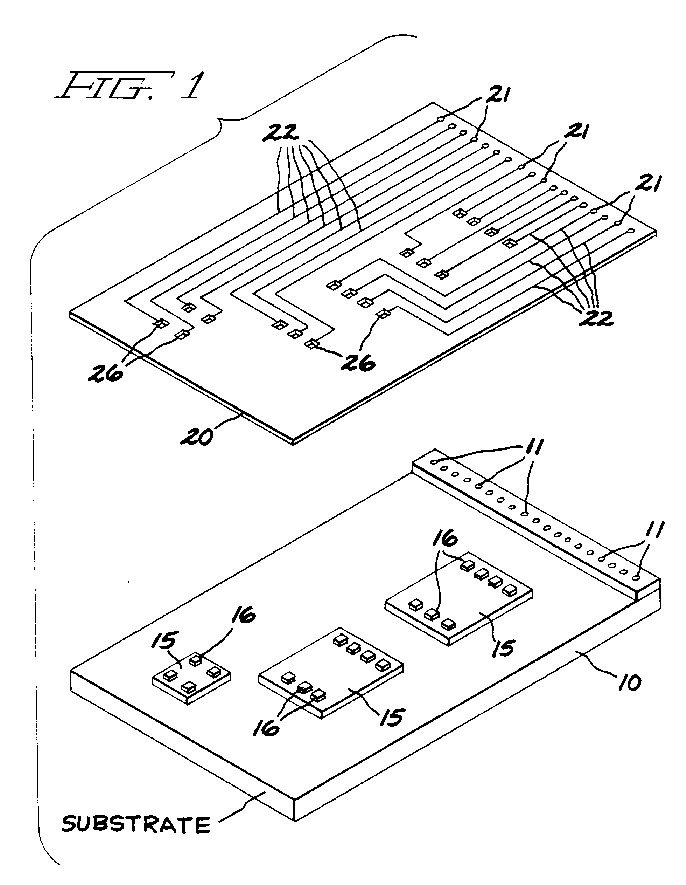

Figure 1 shows an exploded view of a multichip circuit with overlay layer 20 configured so as to test . chips 15 on substrate 10. In a preferred embodiment of the present invention, chips 15 are affixed to substrate 10, as by bonding in place by conventional means using epoxy bonding, thermoplastic bonding, or eutectic die bonding. Polymer overlay layer 20 is applied by the following method. Two coats of a solution of methylmethacrylate in THF (tetrahydrofuran) are sprayed over chips 15 with interconnect pads 16. Each coat is dried at a temperature of approximately 150°C for a period of about 5 minutes. A sheet of acetate film 2.54 x 10$^{-2}$ mm (1 mil) in thickness is laminated to the top of the chips and to package pins 11. A vacuum pressure laminator is preferably employed. Details of a vacuum pressure laminator can be found in application WO88/02551 (RD17433) above. Preferable lamination conditions comprise a pressure of approximately 2.11kg/m$^2$ (30 pounds per square inch) at a temperature of about 120°C for a period of about 3 minutes. The substrate is then cooled to 80°C and removed from the laminator. Via holes over the appropriate chip pads and package pinout pads are fabricated using a focused laser according to the method outlined in application No. WO88/02550 (RD-17,428). Plasma etching is accomplished using somewhat less stringent conditions than required for high stability polymers. For example, one may employ an atmosphere of 30% $CF_4$ and 70% oxygen at a pressure of about 53.32N/m$^2$ (0.4 torr) and at a power level of 200 watts for 6 minutes using a Branson IPC 2000 barrel etcher. Metallization is preferably provided by sputtering a 10$^{-4}$mm (1,000 angstrom) thick layer of titanium, followed by a layer of 10$^{-6}$m (1 micron) thick copper. The metallization is preferably patterned by spraying or spinning a coating of photoresist on the copper surface, drying for about one half hour at approximately 90°C and exposing the positive resist material with a scanned ultraviolet laser under control of computerized artwork. A preferable-photoresist material includes Dynachem OFPR 800 photoresist. Details of a preferred laser exposure system are disclosed in application No. WO88/02550 (RD-17,428). After development of the photoresist, the desired metallization pattern is etched using an acid mix comprising 600 grams of nitric acid, 600 grams of sulfuric acid and 600 grams of $H_3PO_4$ in 1.5 liters of water to remove the copper layer, ifpresent. A mixture comprising 1 part fluoroboric acid and 9 parts water is used to remove the titanium layer. The circuit is now ready for testing according to the metallization pattern illustrated in Figure 1. The pattern of Figure 1 is used to connect package pins 11 to pads 16 on each chip 15, as required for testing. All testing is conducted by applying signals to inputs through the package pins and observing the resultant outputs at the package pins, at least in the embodiment illustrated in Figure 1. It is noted that via holes 26 are aligned with pads 16 on chips 15. It is also noted that vias 21 are aligned with package pins 11. It is further noted that metallization patterns 22 generally extend from via openings 21 to via openings 26 at least for the sample test configuration shown. This pattern may, however, vary over a wide range of patterns.

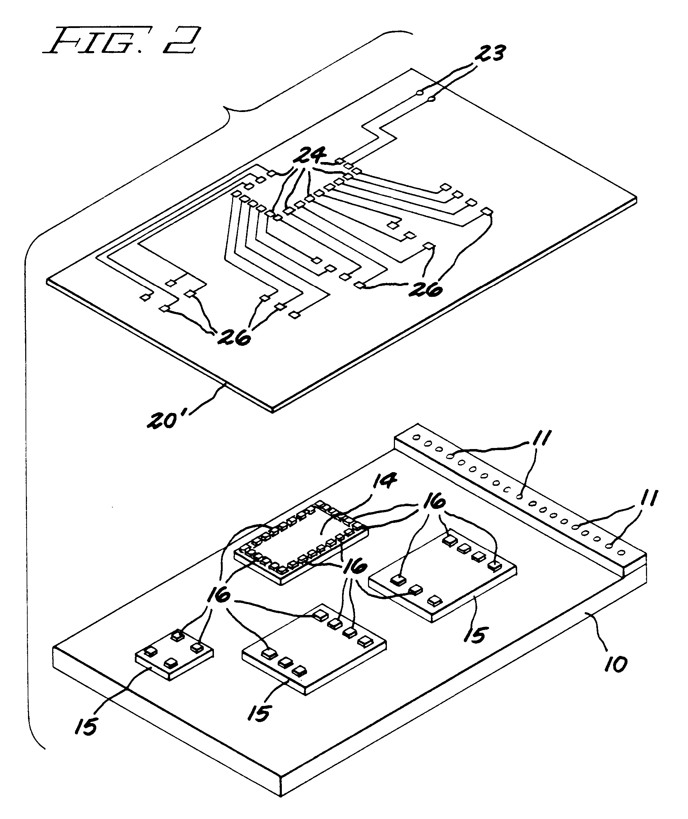

Figure 2 illustrates an alternate embodiment of the present invention in which a test chip 14 is used. Test chip 14 is connected to metallization patterns on overlay layer 20' by means of via openings 24. It is seen in Figure 2 that overlay layer 20' now makes connections between chip pads 16 and test chip 14. It is noted that more than one test chip may be employed even though the figure illustrates only a single one being used. In the example illustrated in Figure 2, only two connections 23 are shown as being required between the test chip and the package pins. It can be seen through the use of the test chip that packaging pins can be conserved.

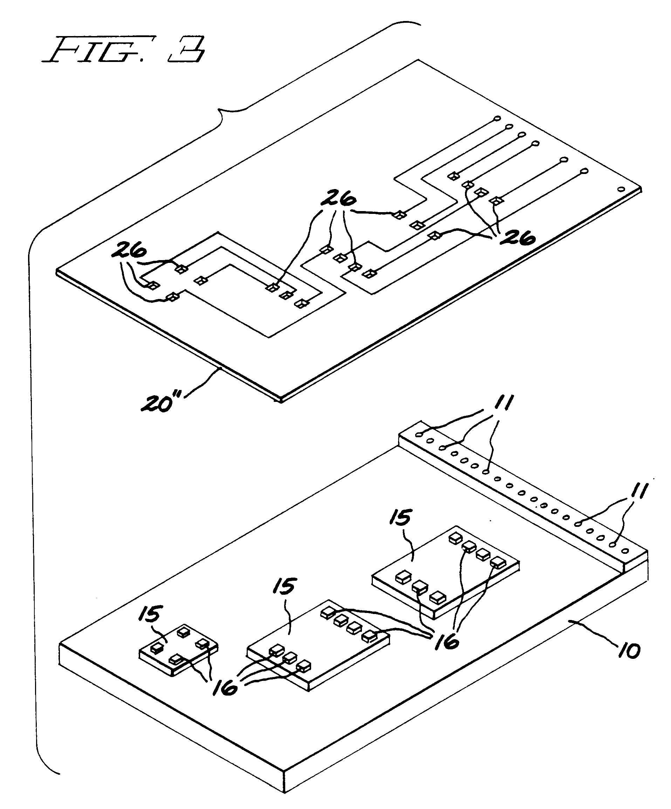

The configuration of Figure 1 or 2 may then be employed to test the chips 15. Following the testing, overlay layers 20 or 20' may be removed. Defective chips may be removed or reconfigured or repositioned on the basis of test results obtained. Subsequently, an operational circuit overlay layer 20'' may be applied to the chip configuration. As a result, the system illustrated in Figure 3 may be produced. It is noted that a difference between Figure 1 and Figure 3 is the particular metallization pattern employed; other differences are discussed hereinafter.

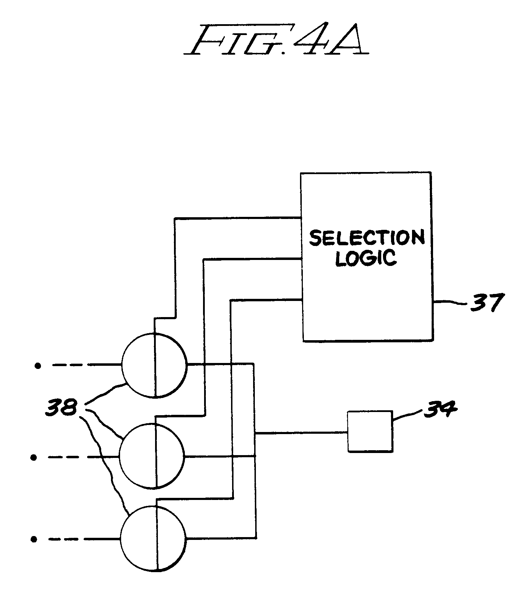

Figures 4A, 4B and 4C show three alternative implementations of test chips. In all cases, these configurations use of circuits and technologies well known to those skilled in the art.

Figure 4A illustrates an array of three transmission gates 38 (typically in CMOS technology). One of the three transmission gates can be selected by selection logic

Under control of the test apparatus, the data selector applies the appropriate signal voltages to transmission gases 38 to turn one of the three gates on and to connect external pad 34 to one of three or more possible internal connection points. It is clear that a number of internal connection points can be multiplexed to one outside pin by this method. The very high density interconnect capability afforded by the overlay layer allows this method to act as a multiprobe connection system.

Figure 4B illustrates an alternate embodiment of the present invention in which memory means 32, such as a random access memory, is employed as a vector generator to supply test vectors to the inputs of a chip or group of chips 15 under test. The output of the chip or group of chips is stored in second memory means 33 also typically comprising a random access memory. Counter 31 driven by clock 30 provides sequential addresses to sequence the output of test vectors and the storage of test results. This system can be run at very high speed, limited only by the speed of the memory means selected. The test vectors are supplied at a much more leisurely pace through external input pins 35. Inspection of the results is achieved in a much more leisurely pace by supplying the contents of memory means 33 to external pins 34. This shows an example of very high speed testing taking place through interconnections in the overlay layer with lower speed connections controlling the testing through external pins 35. It is noted that lines having a hash mark (/) denote multiple signal and/or control paths.

Figure 4C shows a completely internal configuration for high speed testing. In this configuration, microprocessor 40 computes test vectors and supplies them to vector generation random access memory 32. When the requisite number of vectors are input to the memory, the memory is sequentially accessed by the associated counter and the output memory supplies the inputs to a chip or a group of chips 15 under test. The resultant outputs from the test are stored in second memory means 33. At the end of the cycle, microprocessor 40 reads the test results and compares them to computed results to determine if errors have occurred. In this configuration, the entire system can be tested over a long period of time under temperature and variations of other environmental conditions such as electromagnetic interference without any connection, other than power supply, to the outside world. Microprocessors can be used to store test results inconsistent with the expected results, thereby identifying the specific chip or chip group and the failure which occurred, even when the failure occurs on an intermittent basis. Microprocessor 40 is accessed via external pins 41.

When a given test is completed, the test layer is removed according to the following method. First, copper metallization is dissolved in a solution preferably com prising 600 grams of nitric acid, 600 grams sulfuric acid and 600 grams of $H_3PO_4$ in 1.5 liters of water for a period of about 1 minute. This removes copper, but does not attack either aluminum metallization typically present on the chip pads or titanium which is also preferably (though optionally) present as a barrier layer. Titanium is preferably removed by placement in a solution of fluoroboric acid for a period of about 15 seconds. The overlay polymer and adhesive can be removed in a solution of THF for a period of 2 minutes followed by immersion in another clean solution of THF for 1 minute. If a new test layer is to be applied, the test layer process as described above can be started immediately after a defective chip has been removed and a new one put in place. If the final operational overlay layer is to be implemented, a plasma etch to remove any residual polymer is also preferred. Etch conditions preferably include an atmosphere comprising 50% oxygen and 50% $CF_4$ at a total pressure of $53.32N/m^2$ (0.4 torr) for a period of about $2\frac{1}{2}$ minutes in an IPC 2000 barrel etcher at a power level of approximately 300 watts. The final layer is then provided according to the process described in application No. WO88/02551 (RD-17,433). Figure 3 illustrates an exploded view of tested chips on a substrate with an interconnection pattern for an operational circuit. Note that this pattern is completely different from the test patterns shown in Figures 1 or 2. Note also that the materials used for the final operational configuration preferably involve materials of long term thermal and hydrolitic stability such as KAPTON™ (supplied by Dupont de Nemours Company, Inc.) polyimide film. In addition, in the final operational configuration, the metallization used preferably comprises slightly thicker material to obviate any problems associated with electromigration or losses due to resistive paths.

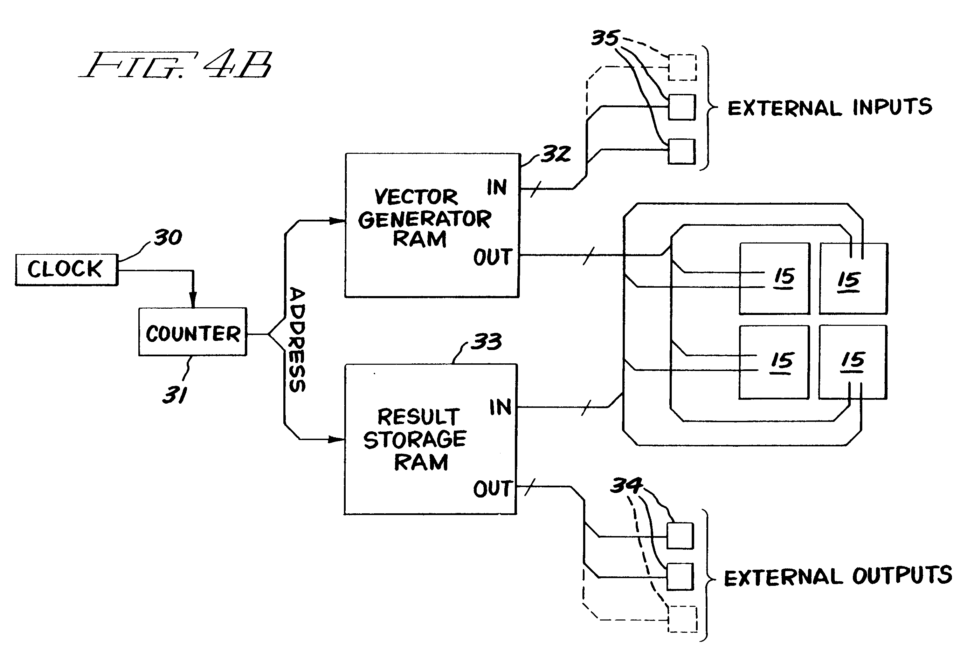

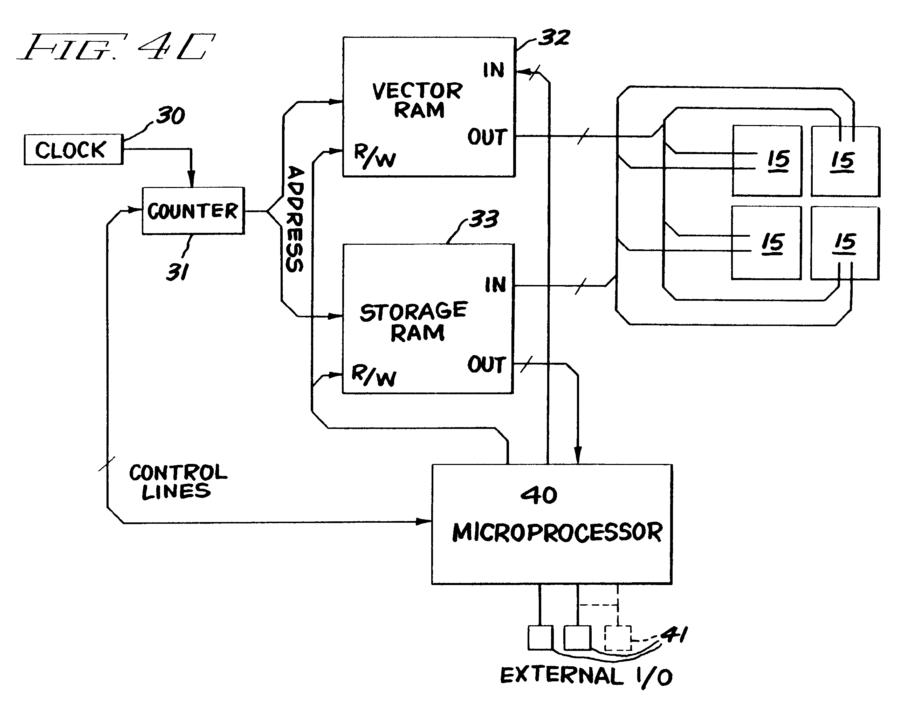

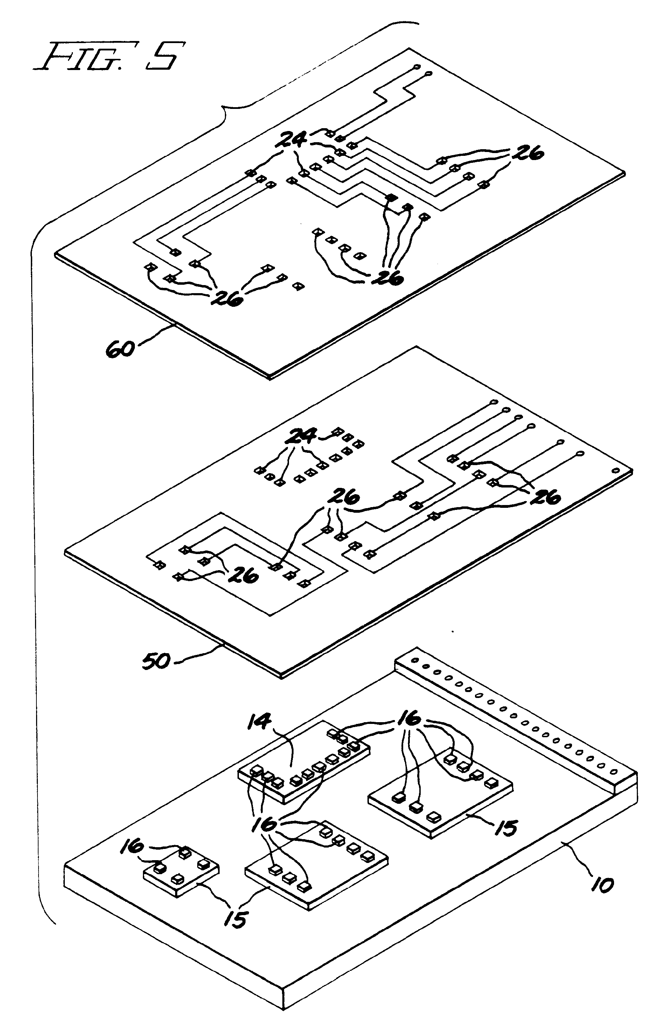

An alternate approach involving the use of an overlay test layer is shown in an exploded view in Figure 5. This is the same circuit as shown in Figure 3 except that additional overlay layer 60 has been added to provide connections to the test chip or chips, and to the test pins or the package. Also note that operational circuit overlay layer 50 is similar to overlay layer 20″ illustrated in Figure 3 except for the presence of apertures 24 for connection to test chip 14. Test layer 60 can be added by spraying a solution of methylmethacrylate in THF and drying at a temperature of approximately 150°C for a period of 5 minutes. Two such coats are generally required. At this point, via holes are fabricated to the connection points on the layer below by using focused laser energy as described in above-mentioned application No. WO88/02550 (RD-17,428). Etch time in an oxygen plasma to clean out the apertures is relatively short since the layer is thin and since the material is highly susceptible to etching. Etch conditions of 200 watts for 4 minutes in an atmosphere comprising 30% $CF_4$ and 70% oxygen at a pressure of $53.32N/m^2$ (0.4 Torr) is sufficient. Metallization is preferably added by sputtering a layer of chrome which is approximately

$10^{-4}$mm (1,000 angstroms) thick, followed by sputtering of sufficient copper for conductivity, typically $10^{-6}$m (1 micron) in thickness. Metallization is patterned, as described above, by a photolithographic method using an etchant of nitric acid, sulfuric acid and $H_3PO_4$ in water, as above. This etchant etches the copper but not the chrome. Chrome is etched in a ceric sulfate solution operated at 60°C. When testing is complete the test layer is easily removed by dissolving the copper in a copper etch solution. This etch attacks the copper, but does not attack the chrome layer. In this way, the underlying chrome layer protects the copper conductor of the underlying layer where it would be exposed at the interconnect points. The chrome is removed with a 25 second etch in the ceric sulfate sulfate solution. The test layer polymer dielectric can be removed in a solution of THF, followed by a second immersion in clean THF to remove any residue. The underlying KAPTON™ film of the operational interconnect overlay is totally unaffected by the THF solvent.

The substrate 10 may be of material selected from the group consisting of glass, metal, ceramic, plastic, silicon and composites.

The polymer film 20′ for testing may be of material selected from the group consisting of thermoplastic materials and thermoset materials.

The high density interconnect system, disclosed hereinabove by way of example, uses a removable overlay layer to provide a method for directly connecting a large number of chips within the same package. The methods disclosed herein provide for the complete test and burn-in of the chip as well as a practical method for partitioning the system into manageable blocks which are easily tested. In addition, in configuration in which the test layer is added after the overlay layers have been interconnected, a removable overlay layer can be used to provide a multiplicity of connections throughout the rest of the system for the purpose of system testing and debugging during and after burn-in. This approach provides the rough equivalence of a "bed of nails" test fixture which is typically used for printed circuit boards but on a pitch of 2.54 x $10^{-2}$mm (1 mil) rather than a pitch of 127 x $10^{-2}$mm (50 mils).

The method and packages disclosed hereinabove by way of example provide various ones of the following objectives:

a method for testing unpackaged interconnected circuits so as to cause minimum capacitive loading on the chips under test so as to thereby allow tests to be conducted at maximum speed;

a method for testing which allows chips to operate in their final locations, such that temperature and environmental conditions (such as electromagnetic interference, radio frequency interference and power supply variations) are all substantially identical to the final desired configuration;

a method for testing which allows long term burn-in of chips without tying up expensive test equipment;

a method for testing which allows the utilization of special chips, thereby eliminating the need for expensive high speed test equipment, allowing the combination of a multiplicity of chips to be tested at once and reducing the number of external connections or package pins required;

a method in which chips can be tested completely with a pad count which exceeds the capability of probe testing with pad sizes which are below the capacity of probe testing;

functional testing of multiply interconnected chips which may be done off-line;

multiple testing configurations by completely changing the interconnect wiring for one or more chips in the system;

a method of making a removable interconnection to a multiplicity of points in an integrated circuit chip system already connected by an overlay interconnect method, thereby allowing for complete system test with minimal increase in external probe, pins and drivers; and/or

effectively, wafer scale integration packages without the concomitant reliability and yield problems associated therewith.

## Claims

1. An integrated circuit chip package (Fig. 2 or Fig. 5) comprising:

a substrate (10);

a plurality of integrated circuit chips (15) disposed on said substrate (10), said integrated circuit chips (15) having interconnect pads (16) thereon;

a removable polymer film overlay (60, 20′) disposed over said chips and said substrate, said film having apertures (26) therein exposing at least some of said interconnect pads; and

a pattern of metallization disposed on said film and connecting selected ones of the interconnect pads through said apertures;

at least one of said chips comprising a test chip operable to test at least one other of said chips.

2. The package of Claim 1 wherein the pattern of metallization on the said polymer film overlay (20′) couples the said selected ones of the said interconnect pads to the test chip for testing the package.

3. The package of Claim 2, wherein the said removable polymer film overlay (60) is disposed over another polymer film (50) having another metallization pattern, the said pattern on the removable film being connected to the said selected ones of the said interconnect pads.

4. The package of Claim 3, wherein the said another polymer film (50) interconnects the said interconnect pads (16) of the chip (15) in the operational configuration of the chips.

5. The package of Claim 3 or 4, wherein the said another polymer film (50) comprises materials of long term thermal and hydrolitic stability.

6. The package of Claim 5, wherein the said another polymer film is of polyimide.

7. The package of any preceding claim Claim, wherein the removable film is of methymethacrylate.

8. The package of any one of Claims 1 to 7, wherein said substrate (10) has external pins (11) for circuit interconnection.

9. The package of any one of Claims 1 to 8, wherein said at least one test chip (14) comprises a microprocessor (40).

10. The package of any one of Claims 1 to 9, wherein said at least one test chip (14) includes memory means (32) for storing test vectors.

11. The package of Claim 9 or 10, wherein said at least one test chip (14) includes memory means (33) for storing test result data.

12. The package of Claim 11, wherein said at least one test chip includes means (35) for externally accessing said vector (32) and result (33) memory means.

13. The package of any preceding claim wherein said substrate material is selected from the group consisting of glass, metal, ceramic, plastic, silicon and composites.

14. The package of Claim 1, 2 or 3, wherein said removable polymer film (20′) is selected from the group consisting of thermoplastic materials and thermoset materials.

15. A method of producing integrated circuit chip packages, said method comprising the steps of:
   a) disposing a plurality of integrated circuit chips (15) on a substrate (10), said chips (15) having interconnect pads (16) thereon;
   b) disposing at least one test integrated circuit chip (14) on said substrate (10), said test chip (14) including means for driving at least one of said plurality of chips; and
   c) disposing a removable polymer film (20′) over said test chip and said at least one of said plurality of chips (15), said film having at least some apertures (26) therein in alignment with said interconnect pads (16) and said film having metallization patterns thereon connecting selected ones of the pads on said test chip (14) to selected ones of the pads (16) on at least one of said plurality of chips (15).

16. The method of Claim 15 further including the step of operating said test chip so as to drive an interconnected configuration of said chips other than said test chip.

17. The method of Claim 16 including, after operating the test chip, the further step of removing said removable polymer film (20′) and applying a further polymer film (20″) having apertures and metallization patterns thereon for connecting said chips (15) in a further configuration.

18. The method of Claim 17, in which said further configuration of apertures and metallization patterns is determined in response to results obtained from operating said test chip.

19. The method of Claim 15, comprising the step of disposing over the plurality of chips (15) a further polymer film (50) having apertures (26) therein in alignment with said interconnect pads (16) of said chips (15) and having metallization patterns thereof for connecting selected ones the interconnect pads of the said plurality of chips in an operational configuration, the said removable polymer film (60) being disposed over the further polymer film (50).

20. The method of Claim 19, comprising the step of operating the test chip (14) and then removing the removable polymer film (60).

21. The method of Claim 16, 17 or 18, comprising the step of removing, reconfiguring or repositioning a chip found, by operation of the test chip, to be defective.

22. The method of any one of Claims 15 to 21, wherein said substrate (10) has external pins (11) for circuit interconnection.

23. The method of any one of Claims 15 to 22, wherein said at least one test chip (15) comprises a microprocessor (40).

24. The method of any one of Claims 15 to 23 wherein said at least one test chip (14) includes memory means (32) for storing test vectors.

25. The method of Claim 23 or 24, wherein said at least one test chip (14) includes memory means (33) for storing test result data.

26. The method of Claim 25, wherein said at least one test chip includes means (35) for externally accessing said vector and result (33) memory.

27. The method of any one of claim 15 to 26 wherein said substrate material is selected from the group consisting of glass, metal, ceramic, plastic, silicon and composites.

28. The method of any one of Claim 15 to 21, wherein said removable polymer film is selected from the group consisting of thermoplastic materials and thermoset materials.

29. A method for producing integrated circuit chip packages, said method comprising the steps of:
   disposing a plurality of integrated circuit chips (15) on a substrate (10), said chips having interconnect pads (16) thereon;
   disposing a removable polymer overlay layer (20′) over said chips, said layer (20) having at least some apertures (26) therein in alignment with at least some of said interconnect pads (16), said layer also having a metallization pattern (22) thereon for connecting said chips in a first configuration);
   testing said integrated circuit chips (15) while connected in said first configuration;

removing said removable overlay layer (20') and said metallization; and

applying a second polymer overlay layer (20'') over said chips and said substrate, said second overlay layer having at least some apertures (26) therein in alignment with at least some of said interconnect pads (16), said second overlay layer also having a metallization pattern thereof for connecting said chips (15) in a second configuration.

## Patentansprüche

1. IC Chip-Paket (Fig. 2 oder Fig. 5) enthaltend:
ein Substrat (10),
mehrere IC-Chips (15), die auf dem Substrat (10) angeordnet sind und auf denen sich Verbindungsstreifen (16) befinden, eine entfernbare Polymerfilm-Überdeckung (60, 20'), die über den Chips und dem Substrat angeordnet ist, wobei in dem Film Öffnungen (26) ausgebildet sind, die wenigstens einige der Verbindungsstreifen freilegen, und
ein Metallisierungsmuster, das auf dem Film angeordnet ist und gewählte Verbindungsstreifen durch die Öffnungen hindurch verbindet,
wobei wenigstens einer der Chips einen Test-Chip (14) aufweist, der zum Testen wenigstens eines anderen der Chips betätigbar ist.

2. Paket nach Anspruch 1, wobei das Metallisierungsmuster auf der Polymerfilm-Überdeckung (20') die gewählten Verbindungsstreifen mit dem Test-Chip verbindet, um das Paket zu testen.

3. Paket nach Anspruch 2, wobei die entfernbare Polymerfilm-Überdeckung (60) über einem weiteren Polymerfilm (50) mit einem anderen Metallisierungsmuster angeordnet ist, wobei das Muster auf dem entfernbaren Film mit den gewählten Verbindungsstreifen verbunden ist.

4. Paket nach Anspruch 3, wobei der weitere Polymerfilm (50) die Verbindungsstreifen (16) des Chips (15) in der Betriebskonfiguration der Chips miteinander verbindet.

5. Paket nach Anspruch 3 oder 4, wobei der weitere Polymerfilm (50) Materialien mit thermischer und hydrolytischer Langzeit-Stabilität aufweist.

6. Paket nach Anspruch 5, wobei der weitere Polymerfilm aus Polyimid besteht.

7. Paket nach einem der vorstehenden Ansprüche, wobei der entfernbare Film aus Methymethacrylat besteht.

8. Paket nach einem der Ansprüche 1 bis 7, wobei das Substrat (10) externe Stifte (11) aufweist für eine Schaltungsverbindung.

9. Paket nach einem der Ansprüche 1 bis 8, wobei der wenigstens eine Test-Chip (14) einen Mikroprozessor (40) aufweist.

10. Paket nach einem der Ansprüche 1 bis 9, wobei der wenigstens eine Test-Chip (14) eine Speichervorrichtung (32) zum Speichern von Testvektoren aufweist.

11. Paket nach Anspruch 9 oder 10, wobei der wenigstens eine Test-Chip (14) eine Speichereinrichtung (33) zum Speichern von Testergebnisdaten aufweist.

12. Paket nach Anspruch 11, wobei der wenigstens eine Test-Chip Mittel (35) aufweist für einen externen Zugriff auf die Vektor-(32) und die Ergebnis-Speichereinrichtung (33).

13. Paket nach einem der vorstehenden Ansprüche, wobei das Substratmaterial aus der aus Glas, Metall, keramik, kunststoff, Silizium und Zusammensetzungen bestehenden Gruppe ausgewählt ist.

14. Paket nach Anspruch 1, 2 oder 3, wobei der entfernbare Polymerfilm (20') aus der aus thermoplastischen Materialien und wärmehärtbaren Materialien bestehenden Gruppe ausgewählt ist.

15. Verfahren zum Herstellen von IC-Chip-Paketen, enthaltend die Schritte:

a) Anordnen von mehreren IC-Chips (15) auf einem Substrat (10), wobei auf den Chips (15) Verbindungsstreifen (16) angeordnet sind,

b) Anordnen von wenigstens einem IC-Test-Chip (14) auf dem Substrat (10), wobei der Test-Chip (14) Mittel aufweist zum Ansteuern von wenigstens einem der mehreren Chips, und

c) Anordnen eines entfernbaren Polymerfilms (20') über dem Test-Chip und wenigstens einem der Chips (15), wobei in dem Film wenigstens einige Öffnungen (26) fluchtend mit den Verbindungsstreifen (16) ausgebildet sind und auf dem Film Metallisierungsmuster ausgebildet sind, die ausgewählte Streifen auf dem Test-Chip (14) mit gewählten Streifen (16) auf wenigstens einem der mehreren Chips (15) verbinden.

16. Verfahren nach Anspruch 15, wobei der Test-Chip so betätigt wird, daß er eine miteinander verbundene Konfiguration von anderen Chips als dem Test-Chip ansteuert.

17. Verfahren nach Anspruch 16, wobei nach dem Betätigen des Test-Chips der entfernbare Polymerfilm (20') entfernt wird und ein weiterer Polymerfilm (20'') mit Öffnungen und mit Metallisierungsmustern darauf aufgebracht wird zum Verbinden der Chips (15) in einer weiteren Konfiguration.

18. Verfahren nach Anspruch 17, wobei die weitere Konfiguration von Öffnungen und Metallisierungsmustern ermittelt wird in Abhängigkeit von Ergebnissen, die aus dem Betrieb des Test-Chips erhalten werden.

19. Verfahren nach Anspruch 15, wobei über den mehreren Chips (15) ein weiterer Polymerfilm (50) angeordnet wird, in dem Öffnungen (26) fluchtend mit den Verbindungsstreifen (16) der Chips (15) ausgebildet sind und der Metallisierungsmuster davon aufweist zum Verbinden von gewählten Verbindungsstreifen der mehreren Chips in einer Betriebskonfiguration, wobei der entfernbare Polymerfilm (60) über dem weiteren Polymerfilm (50) angeordnet ist.

20. Verfahren nach Anspruch 19, wobei der Test-Chip (14) betätigt wird und dann der entfernbare Polymerfilm (60) entfernt wird.

21. Verfahren nach Anspruch 16, 17 oder 18, wobei ein Chip entfernt, rekonfiguriert oder repositioniert wird, der durch den Betrieb des Test-Chip als fehlerhaft befunden worden ist.

22. Verfahren nach einem der Ansprüche 15 bis 21, wobei das Substrat (10) externe Stifte (11) aufweist zum Herstellen einer Schaltungsverbindung.

23. Verfahren nach einem der Ansprüche 15 bis 22, wobei der wenigstens eine Test-Chip (15) einen Mikroprozessor (40) aufweist.

24. Verfahren nach einem der Ansprüche 15 bis 23, wobei der wenigstens eine Test-Chip (14) eine Speichereinrichtung (32) zum Speichern von Testvektoren aufweist.

25. Verfahren nach Anspruch 23 oder 24, wobei der wenigstens eine Test-Chip (14) eine Speichereinrichtung (33) zum Speichern von Testergebnissdaten aufweist.

26. Verfahren nach Anspruch 25, wobei der wenigstens eine Test-ChipMittel (35) für einen externen Zugriff auf die Vektor- und Ergebnisspeichereinrichtung (33) aufweist.

27. Verfahren nach einem der Ansprüche 15 bis 26, wobei das Substratmaterial aus der aus Glas, Metall, Keramik, Kunststoff, Silizium und Zusammensetzungen bestehenden Gruppe ausgewählt ist.

28. Verfahren nach einem der Ansprüche 15 bis 21, wobei der entfernbare Polymerfilm aus der aus thermoplastischen Materialien und wärmehärtbaren Materialien bestehenden Gruppe ausgewählt ist.

29. Verfahren zum Herstellen von IC-Chip-Paketen, enthaltend die Schritte:

Anordnen von mehreren IC-Chips (15) auf einem Substrat (10), wobei auf den Chips Verbindungsstreifen (16) ausgebildet sind,

Anordnen einer entfernbaren Polymerdeckschicht (20') über den Chips, wobei in der Schicht (20) wenigstens einige Öffnungen (26) fluchtend mnit wenigstens einigen der Streifen (16) ausgebildet sind, wobei auf der Schicht auch ein Metällisierungsmuster (22) zum Verbinden der Chips in einer ersten Konfiguration angeordnet ist,

Testen der IC-Chips (15), während sie in der ersten Konfiguration verbunden sind,

Entfernen der entfernbaren Deckschicht (20') und der Metallisierung und

Aufbringen einer zweiten Polymerdeckschicht (20'') über den Chips und dem Substrat, wobei in der zweiten Deckschicht wenigstens einige Öffnungen (26) fluchtend mit wenigstens einigen der Verbindungsstreifen (16) ausgebildet sind, wobei die zweite Deckschicht auch ein Metallisierungsmuster aufweist zum Verbinden der Chips (15) in einer zweiten Konfiguration.

## Revendications

1. Ensemble à puces de circuits intégrés (figure 2 ou figure 5) comprenant :

un substrat (10) ;

un multitude de puces (15) de circuits intégrés disposées sur ledit substrat (10), lesdites puces (15) de circuits intégrés ayant sur leur dessus des plots d'interconnexion (16) ;

un recouvrement amovible par films de polymère (60, 20') disposé sur les puces et le substrat, ce film ayant des ouvertures (26) qui exposent au moins une partie des plots d'interconnexion ; et

un motif de métallisation disposé sur le film et connectant des plots sélectionnés parmi les plots d'interconnexion par l'intermédiaire desdites ouvertures ;

au moins l'une des puces comprenant une puce de test pouvant fonctionner pour essayer au moins l'une des autres puces.

2. Ensemble selon la revendication 1, dans lequel le motif de métallisation sur le recouvrement (20') par film de polymère accouple lesdits plots sélectionnés parmi les plots d'interconnexion à la puce de test pour essayer l'ensemble.

3. Ensemble selon la revendication 2, dans lequel ledit recouvrement amovible (60) par film de polymère est disposé sur un autre film de polymère (50) ayant un autre motif de métallisation, ledit motif sur le film amovible étant connecté auxdits plots sélectionnés parmi les plots d'interconnexion.

4. Ensemble selon la revendication 3, dans lequel ledit autre film de polymère (50) interconnecte les plots d'interconnexion (16) de la puce (15) dans la configuration opérationnelles des puces.

5. Ensemble selon la revendication 3 ou 4, dans lequel ledit autre film en polymère (50) est constitué de matériau présentant une stabilité thermique et hydrolitique à long terme.

6. Ensemble selon la revendication 5, dans lequel ledit autre film en polymère est constitué d'un polyimide.

7. Ensemble selon l'une quelconque des revendications précédentes, dans lequel le film amovible est constitué de méthacrylate de méthyle.

8. Ensemble selon l'une quelconque des revendications 1 à 7, dans lequel ledit substrat (10) comporte des broches externes (11) pour l'interconnexion des circuits.

9. Ensemble selon l'une quelconque des revendications 1 à 8, dans lequel ladite puce de test (14) comprend un microprocesseur (40).

10. Ensemble selon l'une quelconque des revendications 1 à 9, dans lequel ladite puce de test (14) comprend un moyen de mémoire (32) pour stocker des vecteurs de test.

11. Ensemble selon la revendication 9 ou 10, dans lequel ladite puce d'essai (14) comprend un moyen de mémoire (33) pour stocker les données concernant les résultats du test.

12. Ensemble selon la revendication 11, dans lequel ladite puce d'essai comprend un moyen (35) pour accéder extérieurement auxdits moyens de mémoire de vecteurs (32) et de résultats (33).

13. Ensemble selon l'une quelconque des revendications précédentes, dans lequel le matériau du substrat est choisi dans le groupe constitué du verre, des métaux, des céramiques, des plastiques, du silicium et des composites.

14. Ensemble selon la revendication 1, 2 ou 3, dans lequel le film amovible en polymère (20') est choisi dans le groupe constitué des matériaux thermoplastiques et des matériaux thermodurcissables.

15. Procédé de production d'ensembles de puces à circuits intégrés, le procédé comprenant les étapes consistant à :

a) disposer une multitude de puces (15) à circuits intégrés sur un substrat (10), les puces (15) ayant sur leur dessus des plots d'interconnexion (16) ;

b) disposer au moins une puce de test (14) à circuits intégrés sur le substrat (10), cette puce de test (14) comprenant un moyen pour attaquer au moins une puce de la multitude de puces ; et

c) disposer un film amovible de polymère (20') sur la puce de test et sur ladite puce de la multitude de puces (15), le film présentant au moins des ouvertures (26) en alignement avec les plots d'interconnexion (16) et le film ayant sur son dessus des motifs de métallisation qui connectent des plots sélectionnés parmi les plots de la puce de test (14) à des plots sélectionnés parmi les plots (16) placés sur ladite puce de la multitude de puces (15).

16. Procédé selon la revendication (15), comprenant en outre l'étape consistant à faire fonctionner la puce de test de façon à attaquer une configuration interconnectée desdites puces autres que la puce de test.

17. Procédé selon la revendication 16, comprenant, après la mise en fonctionnement de la puce de test, l'étape supplémentaire consistant à enlever le film amovible de polymère (20') et à appliquer un autre film de polymère (20") présentant sur son dessus des ouvertures et des motifs de métallisation pour la connexion des puces (15) dans une autre configuration.

18. Procédé selon la revendication 17, dans lequel cette autre configuration des motifs des ouvertures et de la métallisation est déterminée en réponse aux résultats obtenus à la suite du fonctionnement de la puce de test.

19. Procédé selon la revendication 15, comprenant l'étape consistant à disposer sur la multitude de puces (15) un autre film de polymère (50) comportant des ouvertures (26) en alignement avec les plots d'interconnexion (16) des puces (15) et ayant des motifs de métallisation pour la connexion de plots d'interconnexion sélectionnés au sein de la multitude de puces dans une configuration opérationnelle, le film amovible de polymère (60) étant disposé sur l'autre film de polymère (50).

20. Procédé selon la revendication 19, comprenant l'étape consistant à faire fonctionner la puce de test (14) et à enlever alors le film amovible de polymère (60).

21. Procédé selon la revendication 16, 17 ou 18, comprenant l'étape consistant à enlever, faire une nouvelle configuration ou remettre en position une puce trouvée, défectueuse, par fonctionnement de la puce de test.

22. Procédé selon l'une des revendications 15 à 21, dans lequel le substrat (10) comporte des broches externes (11) pour l'interconnexion des circuits.

23. Procédé selon l'une quelconque des revendications 15 à 22, dans lequel ladite puce de test (25) comprend un microprocesseur (40).

24. Procédé selon l'une quelconque des revendications 15 à 23, dans lequel ladite puce de test (14) comprend un moyen de mémoire (32) pour stocker des vecteurs de test.

25. Procédé selon la revendication 23 ou 24, dans lequel ladite puce de test (14) comprend un moyen de mémoire (33) pour stocker les données des résultats de l'essai.

26. Procédé selon la revendication 25, dans lequel ladite puce de test comprend des moyens (35) pour accéder extérieurement audit vecteur et un moyen de mémoire de résultats (33).

27. Procédé selon l'une quelconque des revendications 15 à 26, dans lequel le matériau du substrat est choisi dans le groupe consituté du verre, des métaux, des céramiques, des plastiques, du silicium et des composites.

28. Procédé selon l'une quelconque des revendications 15 à 21, dans lequel le film amovible en polymère est choisi dans le groupe constitué des matériaux thermoplastiques et des matériaux thermodurcissables.

29. Procédé pour la production d'ensembles à puces de circuits intégrés, le procédé comprenant les étapes consistant à:

disposer une multitude de puces (15) à circuits intégrés sur un substrat (10), les puces ayant sur leur dessus des plots d'interconnexion (16) ;

disposer une couche amovible de recouvrement en polymère (20) sur les puces, cette couche (20) comportant au moins des ouvertures (26) en alignement avec au moins certains des plots d'interconnexion (16), la couche ayant également sur son dessus un motif de métallisation (22) pour connecter les puces dans une première configuration;

essayer les puces (15) à circuits intégrés alors qu'elles sont connectées dans la première configuration;

enlever la couche amovible de recouvrement (20') et la métallisation; et

appliquer une seconde couche de recouvrement en polymère (20″) sur les puces et le substrat, cette seconde couche de recouvrement présentant au moins des ouvertures (26) en alignement avec au moins certains des plots d'interconnexion (16), la seconde couche de recouvrement ayant aussi un motif de métallisation pour connecter les puces (15) dans une seconde configuration.

FIG. 1

SUBSTRATE

FIG. 2

FIG. 3

# FIG.4A

_FIG. 4B_

CLOCK — _30_

COUNTER
_31_

ADDRESS

VECTOR
GENERATOR
RAM

IN — _32_

OUT

RESULT
STORAGE
RAM — _33_

IN

OUT — _34_

_35_

EXTERNAL INPUTS

_15_    _15_

_15_    _15_

EXTERNAL OUTPUTS

EP 0 286 660 B1

FIG. 4C

FIG. 5